Europäisches Patentamt

European Patent Office

Office européen des brevets

(19)

(11) Publication number: **0 121 443**
**A2**

# (12) EUROPEAN PATENT APPLICATION

(21) Application number: **84302308.6**

(22) Date of filing: **04.04.84**

(51) Int. Cl.³: **C 23 C 13/10**

(30) Priority: **04.04.83 US 481619**

(43) Date of publication of application:
**10.10.84 Bulletin 84/41**

(84) Designated Contracting States:
**BE CH DE FR GB IT LI NL**

(71) Applicant: ENERGY CONVERSION DEVICES, INC.
1675 West Maple Road
Troy Michigan 48084(US)

(72) Inventor: Nath, Prem
245 Prospect Road
Rochester Michigan 48063(US)

(74) Representative: Boon, Graham Anthony et al,
Elkington and Fife High Holborn House 52/54 High
Holborn
London, WC1V 6SH(GB)

(54) Apparatus for and method of continuously depositing a highly conductive, highly transmissive film.

(57) An improved method of and apparatus for continuously depositing metallic oxide coatings that are highly electrically transmissive and highly electrically conductive onto a moving substrate. Electromagnetic energy is employed to develop an ionized plasma of metal and oxygen atoms, said plasma adapted for deposition onto the moving, large area substrate which, in the preferred embodiment, includes semiconductor layers thereon. The method and apparatus of this invention are further adapted for the improved, continuous deposition of other transmissive and conductive coatings which include low melting point metals onto the surface of moving plastic, glass or metallic substrate.

EP 0 121 443 A2

./...

Croydon Printing Company Ltd.

FIG.2

APPARATUS_FOR_AND_METHOD_OF_CONTINUOUSLY
DEPOSITING_A_HIGHLY_CONDUCTIVE,_HIGHLY
TRANSMISSIVE_FILM

The present invention relates generally to
methods of  and apparatus for continuously depositing
thin, highly light transmissive, highly electrically
conductive films, and more particularly, to
processes and apparatus for continuously and
efficiently depositing such films onto a substrate
as a step in the production of semiconductor devices.

This invention, in one preferred embodiment,
relates to an improved method of an  apparatus for
continuously depositing a thin,  highly electrically
conductive, highly light transmissive, low melting
point metal oxide film onto the surface of an amorphous
semiconductor material as a step in the manufacture of
photovoltaic devices.  Other preferred embodiments,
disclosed herein, deal with the deposition of low
melting point metal oxide\ films onto the surface of
metal, glass and/or plastic substrates.

Recently, considerable efforts have been made to
develop systems for depositing amorphous semiconductor
alloys, each of which can encompass relatively large
areas, and which can be doped to form p-type and n-type
materials for the production of p-i-n-type cells and
other p-n junction devices which are substantially
equivalent to their crystalline counterparts.

It is now possible to prepare amorphous silicon
and/or germanium alloys by glow discharge deposition or
other substantially equivalent decomposiiton techniques
that have (1) acceptable concentrations of localized
states in the energy gaps thereof, and (2) provide high
quality electronic properties. One such technique is
fully described in U.S. Patent No. 4,226,898, Amorphous
Semiconductor Equivalent to Crystalline Semiconductors, Stanford R. Ovshinsky and Arun Madan which issued October 7, 1980 and another similar, vapor deposition technique is fully described in U.S. Patent No. 4,217,374, Stanford R. Ovshinsky and Masatsugu Izu, which issued on August 12, 1980, under the same title. As disclosed in these patents, fluorine introduced into the amorphous silicon semiconductor material operates to substantially reduce the density of the localized defect states therein and facilitates the addition of other alloying materials.

The concept of utilizing multiple cells, to enhance photovoltaic device efficiency, was discussed at least as early as 1955 by E.D. Jackson, U.S. Patent No. 2,949,498 issued August 16, 1960. The multiple cell structures therein discussed utilized p-n junction crystalline semiconductor devices. Essentially the concept is directed to utilizing different band gap devices to more efficiently collect various portions of the solar spectrum and to increase open circuit voltage (Voc). The tandem cell device has two or more cells with the light directed serially through each cell, with a large band gap material followed by one or more smaller band gap materials to absorb the light passed through the preceeding cell or layer.

Unlike crystalline silicon which is limited to batch processing for the manufacture of solar cells, amorphous silicon alloys can now be deposited in multiple layers over large area substrates to form solar cells in a high volume, continuous processing system. Continuous processing systems of this kind are disclosed, for example, in pending patent applications: Serial No. 151,301, filed May 19, 1980 [US Patent No. 4400409]; serial No. 244,386, filed March 16 1981 for Continuous Systems For Depositing Amorphous Semiconductor Material; Serial No. 240,493, filed March 16, 1981 for Continuous Amorphous Solar Cell Production System [EPA No. 82108699.8] filed September 21, 1982 for Multiple Chamber Deposition And Isolation System and Method; and Serial No. 359,825, filed March 19, 1982 for Method and Apparatus For Continuously Producing Tandem Amorphous Photovoltaic Cells. As disclosed in these applications, a substrate formed from stainless steel, for example, may be continuously advanced through a succession of deposition chambers, wherein each chamber is dedicated to the deposition of a semiconductor material of specific conductivity.

Further, it is now possible to produce amorphous semiconductor devices by a layering or clustering technique in which at least one density of states reducing element and band gap adjusting element is introduced without deleteriously affecting the electrical properties of the alloys. Such processes are disclosed in copending patent application [No. 83305678.1] filed September 23, 1983 entitled Compositionally Varied Materials and Method for Synthesizing the Materials, Stanford R. Ovshinsky.

Following the deposition of the semiconductor alloy layers, regardless of the technique employed to accomplish said deposition, a further deposition process may be performed either in a separate environment or as a part of a continuous process. In this step, a thin, transparent or semitransparent film of electrically conductive, light transmissive material referred to as TCO (transparent conductive oxide) and comprised of, for example, an alloy of indium, tin, and oxygen (ITO) is added. It is the process of an apparatus for depositing such a thin conductive, transmissive film atop a body of amorphous semiconductor material to which the present invention is primarily directed.

Thin, electrically conductive films which are also highly light transmissive in the visible range, have a variety of other important optical and electrical applications. These films may be used, inter alia, as: antistatic coatings, electrodes in photoconductive storage devices, electrodes in liquid crystal and electrochromic displays, photothermal absorption devices; and active and passive layers in photovoltaic devices.

At the present time, thin transparent, conductive metal oxide coatings, used for the purposes outlined hereinabove, commonly comprise: tin oxide materials such as $SnO_2$ and $SnO_2$ doped with antimony or other elements $In_2O_3$ and $In_2O_3$ doped with tin or other elements; or cadmium-oxygen materials such as CdO and cadmium oxide doped with tin. Note however, such materials as $IN_2O_3$, $SnO_2$ and ZnO are regarded as electrical insulators unless combined with a dopant, and formed in a manner which develops a large number of oxygen vacancies. While tin is commonly used to dope indium oxide, other metals, such as cadmium, bismuth and molybdenum may be employed. Similarly, while antimony is commonly used to dope tin dioxide, metals such as Cadmium, molybdenum and indium may also be employed.

The above materials, with tin as a dopant for the indium oxide and antimony as a dopant for the tin dixoide and having indices of refraction which minimize reflection, are particularly well suited for use as thin, electrically conductive light transmissive films on semiconductor materials. This is especially true when they are deposited in about 550 angstrom thicknesses, which optimizes their "optical thickness", to minimize reflection from their surfaces.

Many fabrication processes have been employed to produce the high quality thin, transparent, conductive coatings discussed supra. A first production technique is a sputtering process in which d.c. or r.f. signals generate ions from a working gas, the ions being strongly attracted to, bombard metal-oxide targets, thereby ejecting the metal-oxide material of the targets for deposition onto a substrate. In a variation thereof, referred to as reactive sputtering, d.c. or r.f. sputtering signals are used with metal targets. This process is characterized by a post-ejection reaction of the ejected metal or metals with oxygen to create the material for deposition, the reaction occuring in a plasma generated by the sputtering signal. However, the foregoing processes involve high electrical and kinetic energies, and result in relatively slow rates of deposition. Accordingly, these processes are too time consuming and too energy intensive to be of significant utility in a mass-production process such as the continuous production of large area photovoltaic devices.

Another class of prior art fabrication processes involve the evaporation of a metal into the vapor zone of a vacuumized chamber for reaction of the metal with oxygen, the reaction being activated and enhanced by a plasma. This process is (1) disclosed in U.S. Patent No. 4,336,277, filed September 29, 1980; (2) described by P. Nath and R.F. Bunshah in a publication entitled "preparation of $In_2O_3$ and Tin-Doped $In_2O_3$ Films By A Novel Activated Reactive Evaporation Technique", published in THIN SOLID FILMS Vol. 69 (1980); and (3) taught by P. Nath et al in a paper entitled "Electrical and Optical Properties of $In_2O_3$: Sn Films Prepared By Activated Reactive Evaporation", published in THIN SOLID FILMS, Vol. 72 (1980). As taught by the foregoing, resistive heating is employed to evaporate the metal, and an electron beam from a thermionic emitter is employed to generate a plasma in which the oxides are formed. A pressure, in the range of $10^{-4}$ torr, is required to insure that a sufficient number of metal and gas atoms collide with the electrons and thereby gain sufficient energy to accomplish the metal-oxygen reaction. Further, it is essential that (1) an inert gas such as argon be introduced within the plasma zone to aid in the ionization of the oxygen atoms, and (2) that a magnetic field be employed to move the electrons through the zone in a helical path so as to increase the length of time the electrons remain in the zone, thereby insuring a sufficient number of electron collisions with oxygen and metal atoms.

There is disclosed in Patent Application No. [83307497] of Prem Nath, entitled Apparatus For And Method Of Depositing A Highly Conductive, Highly Transmissive Film, still another procedure for preparing a transparent, electrically conductive layer. In that method, a metallic material is evaporated into a low pressure oxygen atomosphere, and radio frequency energy is employed to generate a plasma in which oxides of the metallic material are formed. These oxides are then deposited onto the substrate, thereby forming the light transmissive, electrically conductive coating. Radio frequency energy is very efficient, vis-a-vis the electrons beam of the prior art process discussed hereinabove. The r.f. energy provides an efficient means for exciting the reactant gases, because high frequency electromagnetic power increases the number of metal atom-oxygen atom collisions, thereby (1) allowing the reaction to occur at lower pressures, and (2) providing a faster, more efficient deposition process. Further, because lower pressures may be employed, higher evaporation rates for the metallic materials may be achieved. And finally, because of the efficiency of r.f. energy in ionizing the reactants, the use of an inert carrier gas to promote ionization can be eliminated, thus simplifying the deposition process and reducing the costs of depositing the transmissive, conductive, transparent layer.

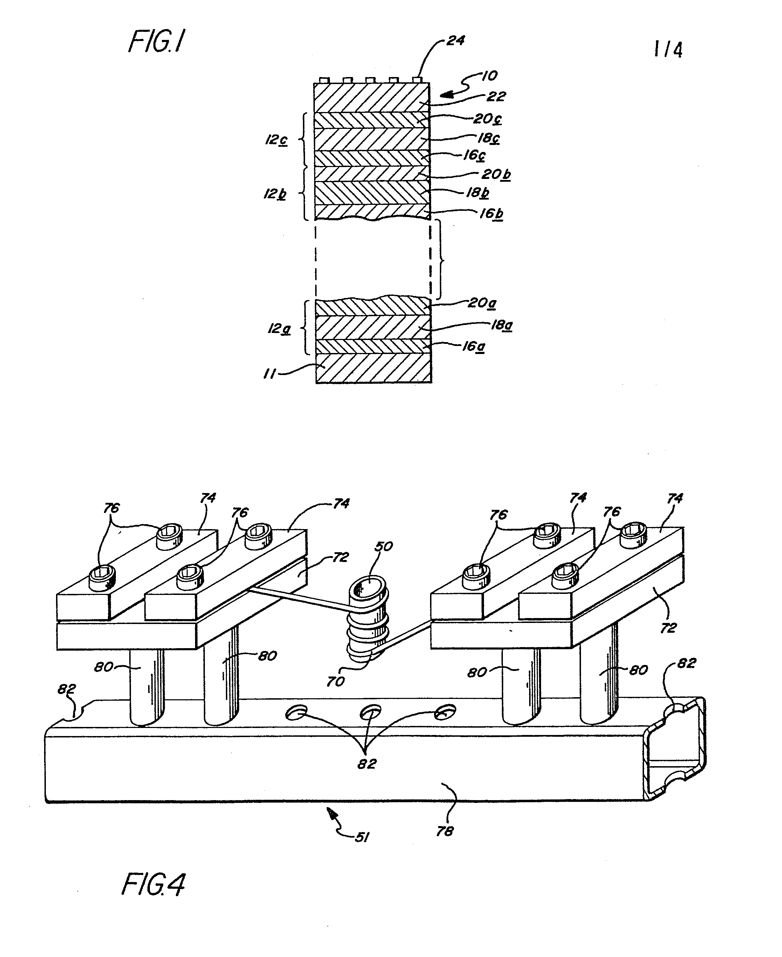

Despite the obvious advantages briefly noted in the foregoing paragraph, the method and apparatus disclosed in the Nath application does not sufficiently describe the method and apparatus for continuously depositing the transparent film onto a roll of substrate  material that can be as much as a thousand feet in length. More particularly, whereas Nath illustrates and discloses, in Figure 2 thereof, apparatus for depositing said transparent layer on a substrate of some finite length, his disclosure of the specifics of the (1) substrate transport system and (2) the metallic material replenishing system require amplication if such apparatus is to be employed for the continuous deposition of the hightly conductive, highly light transmissive materials onto an elongated web of substrate material.

The deposition process and apparatus described herein provides for the continuous, rapid, economical and efficient deposition of layers of transparent materials without the necessity of halting the deposition process to advance the substrate and/or replenish the reactants. The transparent materials so deposited are characterized by high electrical conductivity, high light transmissivity in the visible range, and are preferrebly formed of $InO_3$ doped with tin, $SnO_2$ doped with antimony, or of a ZnO material. The results of tests performed on these materials demonstrate the applicability of the process and apparatus , disclosed herein, to the continuous production of amorphous or crystalline photovoltaic devices which include a substrate, irrespective of whether that substrate is glass, metal or a synthetic plastic resin. The deposition rates which have been achieved are relatively high, the substrate temperature which are required are relatively low and the operational pressures which are required are relatively low. The low temperature which may be employed pursuant to the teaching of the instant invention allows the transparent, conductive layer to be deposited upon amorphous materials, which, if subjected to high temperature, would crystallize. Accordingly, the teachings found herein are specially adapted for depositing the transparent, conductive layer atop a body amorphous semiconductor material.

There is disclosed herein a method of continuously depositing onto a substrate, a thin film that is highly light transmissive in the visible range and highly electrically conductive. The method includes the steps of: vacuumizing a chamber, continuously advancing a substrate through the chamber; providing a replenishable source of metallic material; evaporating the metallic material in the chamber thereby producing a metallic vapor in a zone defined between the substrate and the source of metallic material; introducing oxygen gas into the zone; replenishing the metallic material as it is evaporated from the source; and introducing electromagnetic energy into the zone to develop an ionized plasma from the oxygen and metallic atoms, whereby a metal oxide film is continuously deposited onto the advancing substrate.

The electromagnetic energy is provided by an r.f. power supply adapted to generate an r.f. signal of preferably, about 13.56 megahertz; the pressure of the oxygen gas introduced into the vapor zone is preferably about $10^{-2}$ to $10^{-4}$ torr. The substrate may be (1) stainless steel, aluminum or like conductive metal;

(2) glass; or (3) a synthetic plastic resin.

The metallic material which is evaporated may include (1) indium, with the method including the additonal step of heating the substrate to a temperature of about 150 - 300°C; (2) tin, with the method including the additional step of heating the substrate to a temperature of about 200 - 300°C; or (3) zinc, with the substrate being maintained at about room temperature during the deposition of the film.

The aparatus for continuously depositing the thin, light transmissive, electrically conductive film onto a moving substrate includes: a vacuum chamber; a heater in the chamber; a source of metallic material operatively disposed for evaporation by the heater; a substrate spaced from the source of metallic material, whereby a vapor zone is formed between the source of metallic material and the substrate; means adapted to introduce oxygen into the vapor zone; and means for introducing electromagnetic energy into the zone for developing an ionized plasma from the oxygen gas and metallic atoms in the vapor zone. The improvement includes means for continuously advancing the substrate through the vacuum chamber, and means for replenishing the metallic material as it evaporates from the source. In this manner, the apparatus is adapted to continuously deposit a metal oxide film onto the advancing substrate.

The process and apparatus disclosed herein may be employed to deposit an electrically conductive, light transmissive film onto a glass metal, or plastic substrate, regardless of whether semiconductor material has been previously applied onto the surface of that substrate.

In contrast to prior art processes for depositing thin electrically, conductive, light transmissive films atop, for instance, semiconductor layers, the process and apparatus of the present invention employs electromagnetic energy (an r.f. signal) to form a plasma from the evaporated metal and introduced oxygen atoms. The result is a process: (1) exhibiting higher efficiency ionization (at least one order of magnitude greater ionization than is achieved with the electron emitter); (2) which requires only oxygen to be introduced into the plasma zone, since the ionization is more efficient; (3) capable of operating at much lower substrate temperatures, thereby preventing (a) the crystallization of amorphos semiconductor layers or (b) the melting of plastic substrates; (4) which is well suited for the uniform deposition of material over large area substrates; and (5) which operates continuously to deposit material upon an advancing web, without frequently interrupting the process to replenish materials and remove the coated substrate.

These and other objects and advantages of the present invention will become apparent from the drawings, the detailed description of the preferred embodiments, and the claims which follow.

Figure 1 is a fragmentary, cross-sectional view of a stacked photovoltaic device comprising a plurality of p-i-n- type cells, each layer of the cells formed, in the preferred embodiment, from an amorphous semiconductor alloy;

Figure 2 is a fragmentary perspective view of the apparatus for continuously depositing the light transmissive, electrically conductive layer onto a moving web of substrate material, the apparatus being partially cut-away to reveal the operative components thereof.

Figure 3 is a cross-sectional view taken along line 3-3 of Figure 2 illustrating the continuous deposition apparatus of the present invention;

Figure 4 is an enlarged perspective view of the resistivity heated crucibiles shown in Figures 2 and 3,

- 11 -

said crucibles adapted to operatively receive the metallic material and evaporate same into the vapor zone of the deposition apparatus of the present invention;

Figure 5 is an enlarged perspective view of one preferred embodiment of the present invention in which a wire-like source of metallic material is adapted to be continuously replenished;

Figure 6 is an enlarged perspective view of another preferred embodiment of the present invention in which metallic material is hopper-fed for continuously replenishing the source of metallic material.

I.    The Photovoltaic Cell

Referring now to the drawings and particularly to Figure 1, a photovoltaic cell, formed of a plurality of successive p-i-n- layers, each of which preferably includes a semiconductor alloy, is shown generally by the reference numeral 10.  While the present invention is adapted to be used in conjunction with this type of photovoltaic cell, it is not limited solely to stacked p-i-n type photovoltaic cells, but is of equal use with Schottky or MIS (metal-insulator-semiconductor) type cells; the production of thin-film semiconductor devices; or any device requiring the deposition of a highly conductive, highly transmissive film .

More particularly, Figure 1 shows a p-i-n type photovoltaic device such as a solar cell made up of individual p-i-n solar cells 12a, 12b and 12c.  Below lowermost cell 12a is a substrate 11 which may be transparent or formed from a metallic material such as stainless steel, aluminium, tantalum, molybdemun or chrome.  Although certain applications may require a thin oxide layer and/or a series of base contacts prior to the application of the amorphous material, for the purpose of this application, the term substrate shall

-12-

include not only a flexible film but also any elements added thereto by preliminary processing. In alternate preferred embodiments, the substrate may be formed of (1) glass or other such insulating material with an electrically-conductive coating applied onto one surface thereof; or (2) of synthetic plastic resins, with or without the application of conductive coatings thereto.

Each of the cells 12a, 12b and 12c include a semiconductor body containing, in one embodiment, at least a silicon alloy. Each of the semiconductor bodies includes an n-type conductivity region of layer 20a, 20b and 20c; an intrinsic region or layer 18a, 18b and 18c; and a p-type conductivity region or layer 16a, 16b and 16c. As illustrated, cell 12b is an intermediate cell and, as indicated in Figure 1, additional intermediate cells may be stacked atop the illustrated cells without departing from the spirit of scope of the present invention. Also, although stacked p-i-n cells are illustrated, this invention is equally adapted for single or stacked n-i-p cells. Whereas, in the preferred embodiment of the present invention, an amorphous semiconductor alloy, which includes fluorine, is used to form each of the layers of the cells 12, the layers could also be formed of crystalline or poly-crystalline materials, with or without the addition of fluorine. The inventive concepts disclosed herein are applicable to all thin film semiconductor devices, regardless of materials or crystallinity. As used herein "amorphous" refers to an alloy or material which has long range disorder, although it may have short or even contain at times some crystalline inclusions.

Following the deposition of the semiconductor alloy layers, a further deposition step is performed. In this step, a highly electrically-conductive, highly light transmissive coating 22 is added atop the n-type

-13-

layer 20c; which transparent, electrically-conductive coating may, for example, be a thin, approximately 550 angstrom thick film of indium tin oxide, cadmium stannate, or doped tin oxide. The detailed description which follows, teaches improved processes of and apparatus for continuously depositing such thin, conductive transmissive coatings 22 onto a substrate.

Finally, an electrically conductive grid pattern 24 may be added to the top surface of the transparent, electrically-conductive coating 22 with an electrically conductive paste. For a tandem cell having a sufficiently small area, the transparent conductive coating 22 is generally sufficiently conductive so the grid 24 is not necessary. However, if the cell is of a sufficiently large area, or if the conductivity of the coating 22 is insufficient, the grid 24 may be placed on the layer 22 to shorten the carrier path and increase the efficiency thereof.

II. Apparatus for Continuously Depositing the Conductive, Transmissive Film

Turning now to Figures 2 and 3, the apparatus, of one preferred embodiment of this invention, for continuously depositing a conductive, transmissive film upon a moving substrate is shown generally by the reference numeral 26. The deposition apparatus 26 consists of a supply chamber 28, a deposition chamber 30 and a take-up chamber 32, operatively interconnected so that a web of substrate material 11 may be continuously advanced from the supply chamber 28 through the deposition chamber 30 and into the take-up chamber 32. In the preferred embodiment, the web of substrate material 11 includes layers of semiconductor material deposited thereupon.

Located within the supply chamber 28 is a supply roll 34 having the elongated web of substrate material 11 wound thereabout. It is desirable to provide a protective interleaf layer 36 wound between successive layer of the substrate material 11 so as to prevent scratching of the previously deposited layers of semiconductor material when the substrate is stored in roll form. Accordingly, Figure 2 illustrates a preferred embodiment which includes an interleaf transport system, generally 35 for (1) removing the interleaf material 36 between the layers of the substrate material 11 as the substrate material 11 is unwound from the supply roll 34 in the supply chamber 28, (2) directing the interleaf material 36 away from the substrate material 11 as the substrate material travels through the deposition region in which the conductive transmissive film is deposited thereonto, and (3) reintroducing the interleaf material 36 between adjacent layers of the substrate material 11 as the substrate material is rewound into roll form in the take-up chamber 32.

In order to accomplish the interleaf removal operation, there is provided in the supply chamber 28 a first turning idler roller 38 about which both the substrate 11 and the interleaf 36 are trained. A second turning idler roller 40 is disposed upwardly of the first idler roller 38 and is adapted to receive the interleaf material 36 thereabout, and to direct the interleaf material 36 along a path of travel spaced from the vapor zone 62, which the substrate 11 assumes through the deposition chamber 30.

The roller arrangement in the take-up chamber 32 is substantially a mirror image of that in the supply chamber 28. More particularly, a third turning idler roller 42 receives the interleaf material 36 as it enters the take-up chamber 32 from its path of travel through the deposition chamber 30. The turning idler roller 42 directs the interleaf material to a fourth turning idler roller 44 which, in turn, reunites and interwines the interleaf material 36 between layers of the substrate material 11 as both are wound onto the take-up roller 46.

Although not illustrated, motors and associated drive trains are utilized to advance the web of substrate material 11, such web transport systems being well known in the art and commercially available. Regardless of the transport system employed, it is desirable to (1) use a variable speed electric motor for turning the take-up roller 46 and thereby controlling the speed of the advancing web of substrate material 11 and the interleaf material 36 through the deposition chamber 30 of the apparatus 26; (2) provide means for establishing and maintaining tension in the advancing web of substrate material 11 so that said substrate material presents a substantially taut, planar surface for receiving the transparent layer. The tension may be established by methods such as (1) a friction brake operatively coupled to the supply roll 34 and/or first turning idler roller 38, or (2) a dynamic brake supplied by a counter-rotating electric motor operatively associated with the supply roll 34 and/or first turning idler roller 38. The substrate transport system may also include means for measuring the level of tension on the web of substrate material 11, such as a force transducer or strain gage operatively associated therewith.

The deposition apparatus 26 includes a substrate heater, generally 48, disposed in the deposition chamber 30 and in close proximity to the web of substrate material 11, so as to warm the substrate material 11, thereby facilitating the deposition process. In this embodiment, the substrate heater 48 is a radiant heater, i.e. a plurality of sources 48a of infra-red radiation which is adapted to be absorbed by the substrate material 11 passing therepast. Substrate heating may alternatively be accomplished by other conventional methods which are compatible with the low pressure environment existing within the deposition chamber 30. For example, the substrate material 11 may be inductively heated by a high frequency coil placed in close proximity thereto; or conductively heated by passing the substrate material 11 over a heated surface.

Located within the deposition chamber 30 of the apparatus 26 are one or more evaporation crucibles 50, see Figure 4, or similar evaporation boats through which, in the preferred embodiment, electric current may be passed. The crucibles 50 are supportably positioned relative to apertures in a cathode plate, as described hereinafter, on crucible support assemblies 51.

Associated therewith, are the resistive or inductive heating elements 70 adapted to evaporate the metallic material from the crucibles 50, see Figure 4. Also operatively associated with each of the crucibles 50, is a conduit 54, operatively disposed and connecting the crucibles 50 to a reservoir of metallic material such as storage hoppers 52. In the embodiment of Figures 2-3, the conduit 54 is an elongaged tube connected at the upper end thereof to the hopper 52 and at the lower end thereof to the crucibles 50. The metallic material may take the form of pellets or powder for delivery to the crucibles as detailed hereinafter.

In the preferred embodiment, an apertured cathode plate 56 is located in the deposition chamber 30 in close proximity to but spaced above the crucibles 50. The cathode plate 50 is positioned in a plane generally parallel to the plane assumed by the path of travel of the substrate material 11 as it advances through the chamber 30. The cathode 56 is connected to a source of electromagnetic energy such as radio frequency generator 58, which is, in turn, grounded to the deposition chamber 30. The cathode 56 includes a plurality of spaced openings 53 therethrough, see Figure 2, through which vapor formed by evaporating the metallic material from the crucibles 50 is adapted to pass. Further, disposed within the deposition chamber 30 are a pair of spaced vapor-confining shields 60 for defining a vapor zone 62. In the vapor zone 62, which extends (1) transversely between the walls of the chamber, (2) vertically between the substrate material 11 and the cathode 56, and (3) longitudinally between the spaced shields 60; evapoarated, ionized metallic atoms react with ionized oxygen atoms and energetic neutral atoms to form the metal oxide material which is deposited upon the lower surface of the substrate material 11. While two evaporation shields 60 are shown in this embodiment of the invention, it may be desirable to eliminate one or both, or to employ a greater number of shields depending upon factors such as the size of the chamber, the distance from the crucibles to the substrate, and the surface area of the substrate to be coated. A gas inlet conduit 64 is adapted to introduce oxygen gas into the vapor zone 62 for reacting with the evaporated metallic atoms from the crucibles 50. Note that in contradistinction to prior art reactive deposition processes, the method disclosed herein does not require the introduction of a primary ionizable inert gas to secondarily ionize the reaction gas. This is because of the more efficient ionization produced by the electromagnetic (r.f.) energy.

Also included in the apparatus of Figure 2 is a retaining fixture 68 located in close proximity to (actually slightly below) the moving web of substrate material 11. The fixture 68 is adapted to hold a single sheet of substrate material 11 adjacent the upper portion of the vapor zone 62 for depositing the transparent layer onto said substrate material 11 when the apparatus 26 is employed in its batch processing mode of operation. While the apparatus 26 of the instant invention is particularly adapted to continuously deposit that transparent layer onto a moving substrate 11, it may be desirable to deposit the transparent layer onto discrete large area substrate surfaces. Such applications might include researching and developing improved coating materials and/or optimization of the coating process it may be desirable to prepare relatively small samples of material for limited testing. Accordingly, the retaining fixture 68 provides the deposition apparatus 26 with means for supporting relatively small area, non-moving samples of substrate material 11.

Referring now to Figure 4, the details of the crucible and heater assembly may be seen. As depicted therein, the crucible 50, which may be made of a heat resistant material such as glass, metal or ceramic, has an elongated, wire-like resistance heating element or coil 70 made of tungsten, nichrome or the like, wound about the circumference thereof. The oppositely disposed ends of the heating coil 70 are secured to correspondingly disposed connecting blocks 72 by means of a clamping member 74. More particularly, the clamping member includes bolts 76 adapted to fixedly secure the heating coil 70 between adjacent connecting blocks 72. The connecting blocks 72 and the clamping members 74 are preferably made of a highly electrically conductive material such as copper, and serve to carry electrical current to the resistance element 70 from a power supply, not shown in this drawing. The connecting blocks 72 are attached to a support base 78 by means of electrically insulated ceramic pillars 80. The support base 78 further includes a plurality of spaced appertures 82 therein, the appertures 82 being sized and spaced to provide for repositioning of the crucible 50 and connecting blocks 72 within the deposition chamber 30 of the apparatus 26 so as to optimize the pattern of metallic evaporation from the crucible 50 and through the cathode 56. In this manner a substantially uniform coating of transparent material will be deposited atop the substrate material 11. More specifically, and as disclosed in U.S. Patent Application Serial No. 448,139, the spacing of the evaporation crucibles 50 from the substrate material 11 and from other adjacent crucibles 50 determines the pattern of transparent material deposited atop the substrate material, and is therefore responsible for the thickness and uniformity of the deposited transparent layer. Accordingly, the teaching of said Patent Application [83307497.4] is incorporated herein by reference and the crucibles 50 of the instant invention are preferably spaced equidistantly from each other and the substrate 11 to deposit a substantially uniform transparent layer.

While the drawings depict resistively heated crucibles, the apparatus and method of the instant invention are not limited to this mode of heating. Any method of metal evaporation known in the art may be advantageously employed in conjunction herewith. For example, inductive heating may be useful in some applications, while electron beam heating will be useful in others. One determining factor in the choice of heating mode will be the melting point of the material being evaporated.

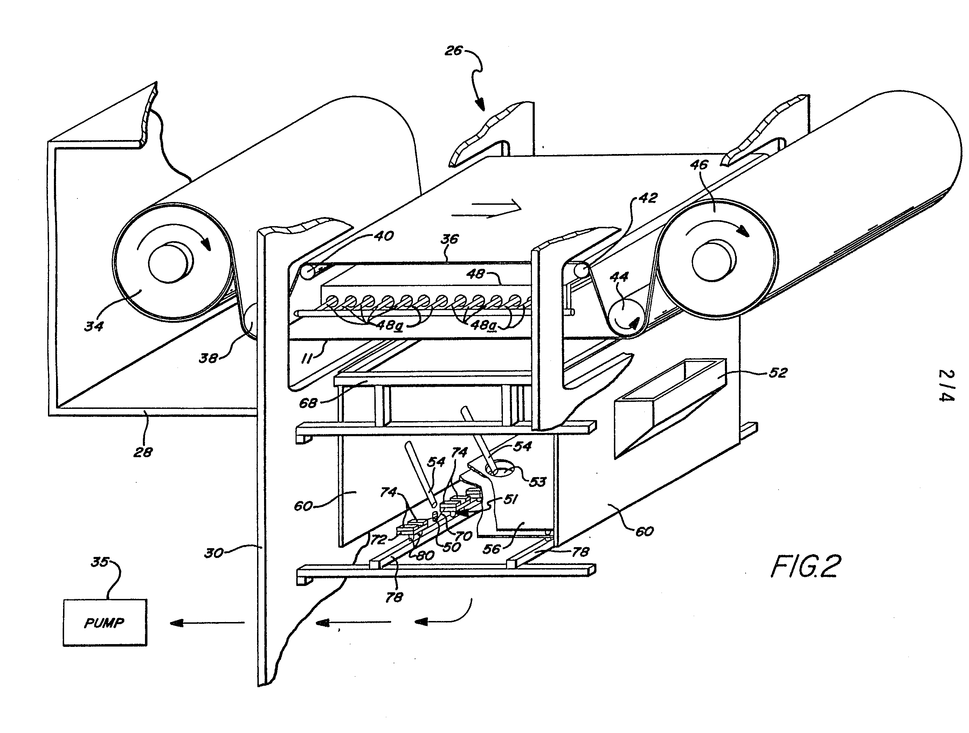

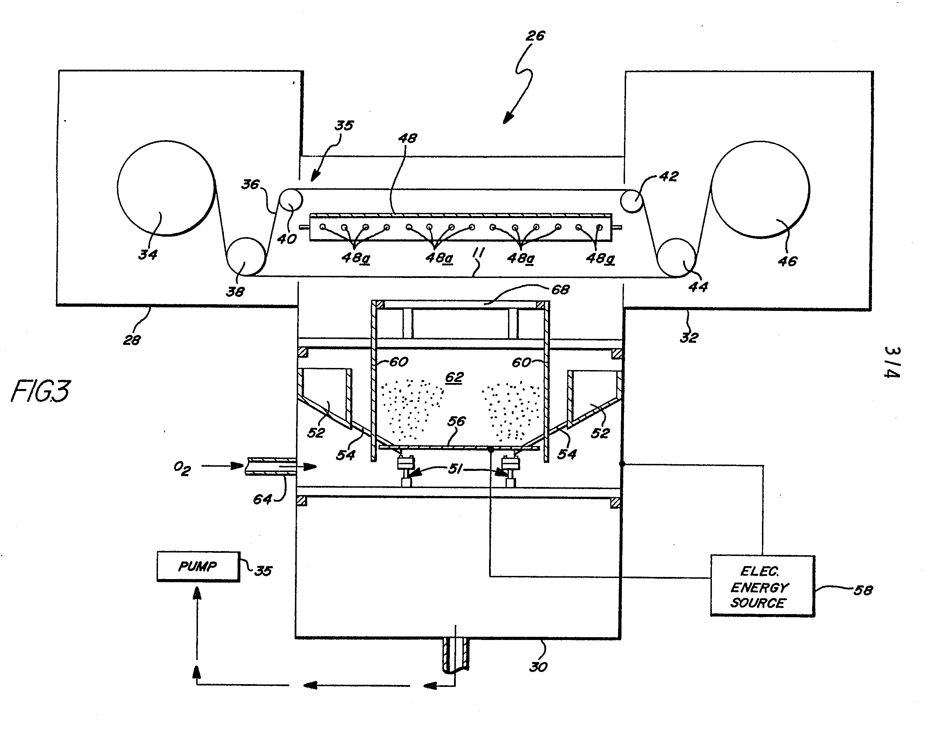

Figure 5 illustrates a first embodiment for continuously replenishing the metallic material as it evaporates into and disperses through the vapor zone 62. In the evaporation apparatus, generally 81, the metallic material 84 is formed as an elongated, thin ribbon which is wound about a dispensing spool 86. The spool 86 is rotatably mounted by an axle 83 to cantilevered struts 85 attached to the feed mechanism housing 88. Within the housing 88, a ribbon feed mechanism, not shown, advances the ribbon of metallic material 84 to a heated evaporation plate 90, where, upon contact therewith, flash vaporisation of the metallic occurs. The evaporation plate 90 is depicted in Figure 5 as a generally planar member, although crucible-like shapes could also be utilized without departing from the spirit and scope of the present. invention. The flash evaporation technique, described hereinabove, employing a ribbon of metallic material 84 and an evaporation plate 90, has particular utility where a metallic material formed from several elements having diverse vapor pressures is to be evaporated. If such a diverse material were placed into a crucible, vaporization of the components would occur on a piece-meal basis, thereby rendering compositional control of the vaporized material very difficult, vis-a-vis, the instantaneous vaporization made possible by flash evaporation.

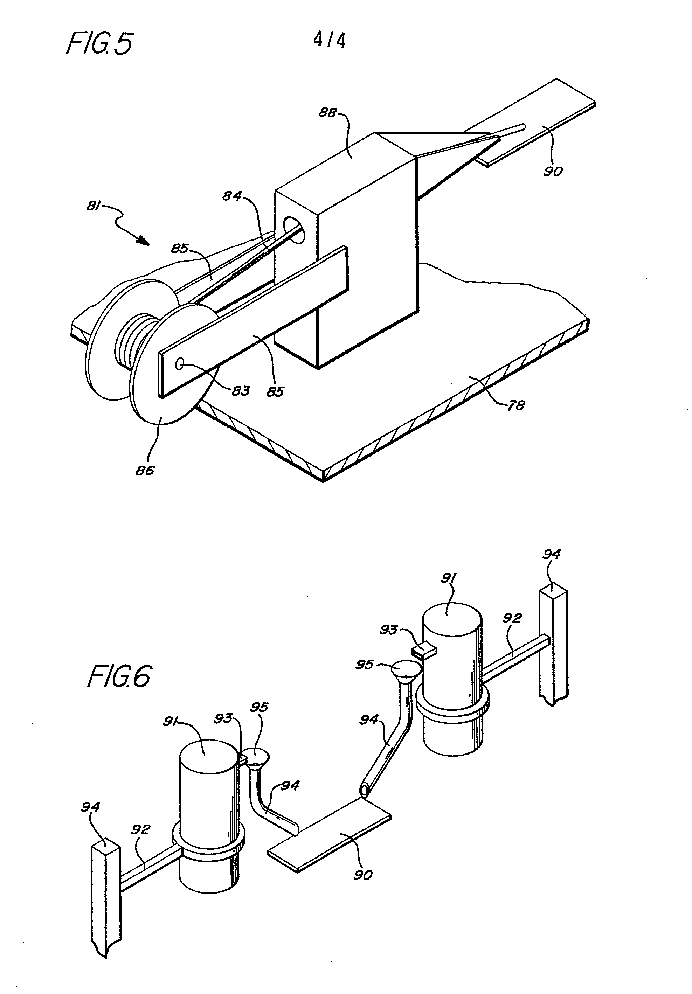

Figure 6 depicts a still further embodiment for continuously replenishing the metallic material as it evaporates from the evaporation plate 90 into and disperses through the vapor zone 62. In this embodiment the metallic material is housed in two spaced storage hoppers 91, from which said material is ejected by mechanical vibration thereof. The vibration may be accomplished by means of a mechanical linkage 92 connecting the hopper 91 to a vibrating element 94. The metallic material ejected from the hoppers 91, whether in powder or pellet form, is routed from a spout 93 of the hopper 92 to the evaporation plate 90 via an elongated feed conduit 96 having a funnel shaped upper end 95. Other methods of replenishing the material may be used in keeping with the spirit of the instant invention.

III. DEPOSITING THE CONDUCTIVE, TRANSMISSIVE COATING

The operation of the deposition apparatus 26 of the instant invention can best be understood by referring to the perspective view of Figure 2. Prior to evacuation of the deposition apparatus 26, a rolled web of substrate material 11 is placed on the supply roller 34 in the supply chamber 28, threaded through thd chambers of the deposition apparatus 26 and secured to the take up roller 46 in the take-up chamber 32. Correspondingly, the interlead material 36 is trained about the idler rollers 38 and 40 in the supply chamber 28, fed through the deposition chamber 30, trained about the idler rollers 42 and 44 in the take-up chamber 32, and finally wound between layers of the substrate material 11. The crucibles 50 and the supply hoppers 52 are loaded with the metallic material, and the system is sealed to the atmosphere.

The apparatus 26 is evacuated by means of a pumping system, shown schemmatically as 35, to a pressure of $10^{-4}$ to $10^{-6}$ torr and oxygen gas is introduced to raise the pressure within the apparatus to $10^{-2}$ to $10^{-4}$ torr. The cathode plate 56 is then energized by the source of electromagnetic energy, such as a radio frequency signal of about 13.56 megahertz, thereby generating a plasma from the materials introduced into the vapor region 62. The substrate heater 48 is activated, so as to maintain the substrate 11, at a predetermined deposition temperature (room temperature to 400°C). The crucibles 50 are heated by energizing the resistance coils 70 or other evaporation apparatus associated therewith, thereby causing vaporization of the metallic material into the vapor region 62. The electromagnetic energy excites and ionizes the oxygen atoms introduced and the metal atoms evaporated thereinto. Reaction between the metal atoms and the oxygen atoms produces oxides of the metallic material which are deposited onto the surface of the substrate material 11.

The rate of travel of the web of substrate material 11 through the deposition chambers, which is regulated by controlling the speed of the take-up roller, 46, provides for the deposition of a preselected thickness of metallic oxide material. As the deposition proceeds, the metallic material evaporated from the crucibles 50 is continuously replaced by the material in the supply hoppers 52, and oxygen consumed by the reaction in the vapor zone 62 is continuously replenished by admitting oxygen gas into the chamber, so as to maintain the deposition apparatus 26 at a constant pressure. It has been found that transparent, uniform coatings exhibiting the characteristics of high electrical conductivity and high light transimissivity may be deposited upon the continuously advancing web of substrate material 11, according to the principles of the instant invention.

For example, by utilizing a metallic material composed of 85 atomic percent indium and 15 atomic percent tin, providing a substrate temperature òf 150° C to 300 °C, and an oxygen pressure of $10^{-2}$ to $10^{-4}$ torr, the method and apparatus of the present invention will produce an approximately 1000 A thick layer of indium tin oxide having a sheet resistance of 2 to 100 oms/square and a white light transmissivity greater than 90%.

In a like manner, a 1500 A thick tin-antimony oxide film exhibiting a sheet resistance of 80 ohms/square and a white-light transmissivity greater than 90%, was prepared. The starting material was a mixture of 90 atomic percent Sn, and 10 atomic percent Sb, the pressure of oxygen was $2.5 \times 10^{-3}$ torr, and the substrate was maintained at a temperature of 250°C during the deposition.

While the apparatus and method of the instant invention have been described with reference to the fabrication of transparent, electrically conductive light transmissive layers, the invention is not limited. Accordingly, insulating and/or refractory layers such as silicon nitride, aluminum nitride, boron nitride, germanium oxide and the like may also be prepared pursuant to the above described methods and utilizing the above described apparatus. Aspects of the method and the apparatus of the instant invention may be readily adapted to more efficiently deposit material onto a continuously moving substrate wherein an evaporated material reacts with another vapor to form a new depositable material.

The present invention is not limited to the precise structures and methods of the illustrated embodiments. It is intended that the foregoing description of the present preferred embodiments be regarded as illustration rather than as a limitation of the present invention. It is the following claims, including all equivalents which are intended to define the scope of this invention.

CLAIMS:

1. A method of continuously depositing a thin light transmissive, electrically conductive film onto a moving substrate, the method including the steps of:

vacuumizing a chamber;

continuously advancing a web of substrate material through the chamber;

providing a source of metallic material;

evaporating the metallic material in the vacuumized chamber, whereby a metallic vapor is produced in a zone defined between the substrate and the source of metallic material;

replenishing the metallic material as it evaporates from the source,

introducing oxygen gas into the zone;

introducing electromagnetic energy into the zone to develop an ionized plasma from the oxygen gas atoms introduced and the metalllic atoms evaporated into the zone, whereby a metal oxide film is adapted to be continuously deposited onto the moving substrate.

2. A method as in claim 1, which includes the further step of replenishing the oxygen gas as it reacts with the metallic material, whereby a substantially constant partial pressure of oxygen is maintained in the chamber.

3. A method as in claim 1, wherein the metallic material has a melting point of less than 450°C.

4. A method as in claim 2, wherein the metallic material is selected from the group consisting of indium, tin, cadmium, zinc and mixtures thereof.

5.    A method as in claim 1, including the
further step of heating the substrate to 150 - 400°C.

6.    A method as in claim 5, wherein the substrate
is heated to a temperature of 150 - 300°C, and
an indium-tin compound is evaporated in the chamber;
whereby indium-tin oxide is continuously deposited
onto the surface of the moving substrate.

7.    A method as in claim 6, wherein the
electromagnetic energy is provided by an r.f.
power source adapted to energize a cathode disposed
within said zone, said cathode adapted to be
energized to a frequency of about 13.56 megaherz.

8.    A method as in claim 6, wherein the pressure
within the chamber is maintained at about $10^{-2}$
to $10^{-4}$ torr.

9.    A method as in claim 1, wherein the metallic
material is zinc and the substrate is maintained
at room temperature.

10.    A method as in claim 5, wherein the metallic
material is indium and the substrate is heated to
a temperature of less than about 300°C.

11.    A method as in claim 1, wherein the substrate
includes a semiconductor body atop of which the
metallic oxide film is deposited.

12.    A method as in claim 11, wherein the semiconductor body comprise a plurality of amorphous
semiconductor layers.

13. Apparatus for continuously depositing a light transmissive, electrically conductive film onto a substrate, said apparatus including: a vacuum chamber; heating means in the chamber; a source of metallic material operatively disposed for evaporation by the heating means; a substrate spaced from the source of metallic material; a vapor zone formed between the source of metallic material and the substrate; means for introducing oxygen into the vapor zone; and means for introducing electromagnetic energy into the zone to develop an ionized plasma from the oxygen gas and the metallic atoms in the vapor zone; the improvement comprising, in combination:

     means for continuously advancing the substrate through the apparatus; and,

     means for continuously replenishing the metallic material as it evaporates, whereby the apparatus is adapted to continuously deposit a metal oxide film onto the advancing substrate.

14. Apparatus as in Claim 13, further including means for replenishing the oxygen as it reacts with the metallic material, whereby a substantially constant partial pressure of oxygen is maintained in the chamber.

15. Apparatus as in claim 13, wherein means for heating the substrate is provided.

16. Apparatus as in claim 13, wherein further including a plurality of spaced sources of metallic material adapted to be evaporated by the heating means.

17. Apparatus as in claim 13, wherein the means for heating the source of metallic material is a resistance heater.

18.    Apparatus as in claim 13, wherein the means for heating the source of metallic material is an induction heater.

19.    Apparatus as in claim 13, wherein the means for heating the source of metallic material is an electron beam.

20.    Apparatus as in claim 13, wherein the substrate comprises an elongated web of material, and the means for continuously advancing the substrate through the apparatus comprises a plurality of rollers and drive means associated therewith.

21.    Apparatus as in claim 13, wherein the means for replenishing the metallic material comprises, a storage hopper in which the material is stored and a conduit for conveying the material from the hopper to the source.

22.    Apparatus as in claim 13 wherein the metallic material is an elongated relatively thin wire, and the means for replenishing the metallic material comprises; a spool, about which the metallic wire is coiled, and feed means adapted to advance the metallic wire from the spool to the source, whereby the metallic material may be continuously replenished.

23.    Apparatus as in claim 13, wherein the energy means includes a cathode plate, said cathode plate moving cathode at least one opening through which the vaporized atoms of the metallic material are adapted to pass to the vapor zone.

24.    Apparatus as in claim 13, including means for maintaining the chamber at a pressure of $10^{-2}$ to $10^{-5}$ torr.

25. Apparatus as in claim 13, wherein the metallic material is selected from the group consisting of indium, cadmium, zinc and mixture thereof.

26. Apparatus as in claim 26, wherein the substrate includes a semiconductor body on the surface of which the metallic oxide film is adapted to be deposited.

27. Apparatus as in claim 13, wherein the semiconductor body comprises a plurality of amorphous semiconductor layers.

28. Apparatus as in claim 25, wherein the substrate is formed from stainless steel.

29. Apparatus as in claim 25, wherein the substrate is formed from a synthetic plastic resin.

30. Apparatus as in claim 25, wherein the substrate is formed from a glass-like material.

FIG.1

0121443

1/4

FIG.4

FIG.2

FIG 3

FIG.5

88

84

81

85

90

85

83

86

78

FIG.6

91

93

92

94

95

94

90

91

93

95

94

94

90

92

94